# EUROPÄISCHE PATENTSCHRIFT

(11) **EP 1 589 541 B1**
(45) Veröffentlichungstag und Bekanntmachung des Hinweises auf die Patenterteilung: **30.05.2007**
(21) Anmeldenummer: 04009198.5
(22) Anmeldetag: 19.04.2004
(51) Int. Cl.: H01B 9/00, H01B 7/04, H01B 11/10

(54) **Flexible elektrische Energie- und Steuerleitung**
Flexible electric power and control cable
Câble électrique flexible de commande et de puissance

(43) Veröffentlichungstag der Anmeldung: 26.10.2005
(73) Patentinhaber: Nexans, 75008 Paris (FR)
(72) Erfinder: Grögl, Ferdinand, Ing., 90403 Nürnberg (DE); Mann, Thomas, Ing., 91367 Weissenohe (DE)
(74) Vertreter: Döring, Roger

(56) Entgegenhaltungen:
- DE-U- 20 205 484
- US-A- 5 530 203
- US-A1- 2003 121 694
- US-A1- 2004 050 582

## Beschreibung

Die Erfindung betrifft eine flexible elektrische Steuerleitung gemäß dem Oberbegriff des Patentanspruchs 1.

Derartige Steuerleitungen - im folgenden kurz "Leitungen" genannt - werden beispielsweise zum Verbinden von ortsveränderlichen Geräten mit einer Spannungs- bzw. Signalquelle eingesetzt. Ortsveränderliche Geräte können beispielsweise Kräne, Werkzeugmaschinen und Roboter sein. Die Leitungen müssen mechanisch belastbar sein, mit einer auf lange Zeit gleichbleibenden Biegefestigkeit, beispielsweise beim Einsatz in Energieschleppketten. Sie sollen auch in einem weiten Temperaturbereich flexibel bleiben, der beispielsweise zwischen -40 °C und +80 °C liegt.

In der Seele der bekannten Leitung nach der DE 101 62 739 A1 sind eine der Stromversorgung dienende Versorgungsader und zwei Datenübertragungsleitungen um ein zentrales Kernelement herum angeordnet. Die Datenübertragungsleitungen weisen jeweils zwei isolierte Adern auf, die von einer gemeinsamen Abschirmung umgeben sind. In der Seele der Leitung sind außerdem aus je zwei miteinander verseilten und von einer gemeinsamen Abschirmung umgebenen Adern bestehende Niederfrequenzleitungen vorhanden. Eine solche auch als "Hybridleitung" bezeichnete Leitung weist als einheitliches Gebilde alle zur Übertragung von Energie, Daten und Steuersignalen benötigten Elemente auf. Gesonderte Leitungen werden daher nicht benötigt.

Die US-A-5 530 203 beschreibt eine kombinierte elektrische Leitung mit zentral angeordneten Versorgungsleitern und außen liegenden Signaladern. Die Versorgungsleiter sind von elektrischen Schirmen umgeben, an denen auch Beilaufdrähte anliegen. Um die Schirme herum ist eine Isolierschicht angebracht, um die herum eine große Anzahl von Signaladern angeordnet ist, die jeweils zu Paaren miteinander verseilt und von einer Aluminiumfolie umgeben sind. Zwischen je zwei Paaren ist ein Beilaufdraht angeordnet.

Aus dem eingangs erwähnten DE 202 05 484 U1 geht ein Übertragungskabel mit drei Busleitungen und einer Versorgungsleitung hervor. Die Busleitungen dienen zur Übertragung von Daten. Zwei der Busleitungen bestehen aus zwei miteinander verseilten Adern mit geschäumter Isolierung, die von einer Schicht aus Isoliermaterial umgeben sind, über der ein mehrlagiger Schirm und eine Ummantelung aus Isoliermaterial angebracht sind. Die Busleitungen und die vieradrige Versorgungsleitung sind zusammen mit einem Schutzleiter und Füllelementen unter Zwischenlage einer Umwicklung von einem Mantel aus flammwidrigem und halogenfreiem Polyurethan umgeben.

Der Erfindung liegt die Aufgabe zugrunde, die eingangs geschilderte Leitung so zu gestalten, daß bei einfachem Aufbau gute elektrische Übertragungseigenschaften und eine auf Dauer wirksame elektrische Schirmung gewährleistet sind, mit einer einfachen Entkopplung von Signaladern einerseits und Versorgungsader andererseits.

Diese Aufgabe wird entsprechend den kennzeichnenden Merkmalen des Patentanspruchs 1 gelöst.

Diese Leitung kann in üblicher Technik unter Einsatz von grundsätzlich bekannten, einfach aufgebauten Maschinen und zugehörigen Vorrichtungen hergestellt werden. Sie hat hervorragende elektrische Übertragungseigenschaften, insbesondere für die Datenübertragung mit den mit einer geschäumten Isolierung versehenen Signaladern. Da die Versorgungsadern in den beiden einander gegenüber liegenden Zwickeln der beiden Signaladern angeordnet sind, stehen die beiden unterschiedlichen Leitungskreise senkrecht aufeinander. Sie sind dadurch vom Aufbau der Leitung her sehr gut voneinander entkoppelt. Sowohl für die Signaladern als auch für die Versorgungsadern ergibt sich durch den Einsatz des metallisierten Kunststoffvlieses eine sehr gute Abschirmung. Die beiden Versorgungsadern sind dabei insbesondere einzeln sehr gut abgeschirmt. Das elektrisch leitende, metallisierte Kunststoffvlies besteht beispielsweise und vorzugsweise aus Polyester. Zur Erzeugung einer nahezu geschlossenen metallischen Schicht wird auf dem Vliesmaterial ein Metall, vorzugsweise Aluminium oder Kupfer, aus der Dampfphase abgeschieden. Es schlägt sich dabei nicht nur auf der äußeren Oberfläche des Vliesmaterials nieder, sondern dringt auch in dasselbe ein und umhüllt dessen innere Fasern, die bekanntermaßen ungeordnet im Vliesmaterial zusammengehalten sind. Das Vliesmaterial ist dann "durchdringend" beschichtet. Es hat dadurch eine zwar poröse, aber trotzdem nahezu vollständig geschlossene Metallschicht, die eine Bedeckung der umschlossenen Elemente der Leitung mit elektrisch wirksamem, metallischem Material von > 85 % ergibt. Der elektrisch wirksame Schirm der Leitung mit einem ausreichenden leitenden Querschnitt ist durch die mindestens eine, vorzugsweise aus verzinnten Kupferdrähten bestehende Beilauflitze vervollständigt, die sowohl an der Abschirmung der Signaladern als auch an der äußeren Abschirmung anliegt. Die über der äußeren Abschirmung angeordnete, vorzugsweise aus Kupferdrähten bestehende Schirmlage garantiert für die Leitung sehr gute EMV-Eigenschaften. Sie kann als Geflecht oder Umseilung ausgeführt sein.

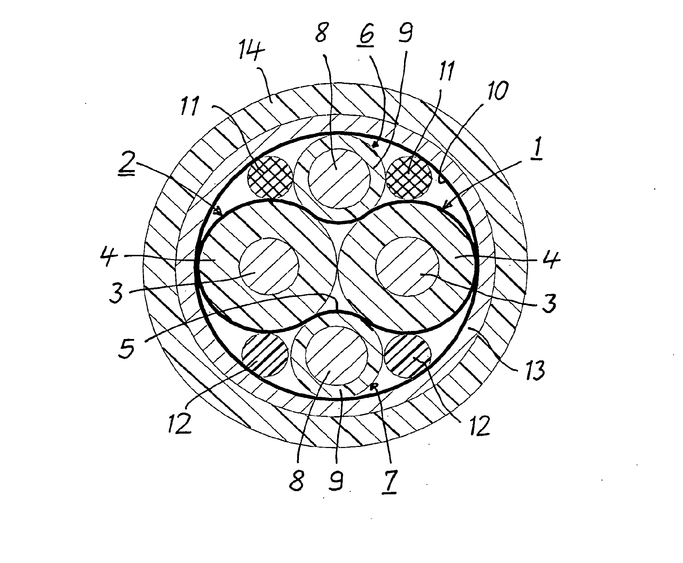

Ein Ausführungsbeispiel des Erfindungsgegenstandes ist in der Zeichnung dargestellt.

Die einzige Figur der Zeichnung zeigt einen Querschnitt einer Leitung nach der Erfindung.

Die in der Zeichnung im Querschnitt dargestellte Leitung hat zwei Signaladern 1 und 2, von denen jede einen vorzugsweise aus Kupfer bestehenden Leiter 3 aufweist, der von einer Isolierung 4 umgeben ist. Der Leiter 3 kann ein massiver Draht oder ein Litzenleiter sein. Er kann eine äußere Schicht aus Zinn, Silber oder Nickel aufweisen. Der Leiter 3 kann auch aus einer cadmiumfreien Kupferlegierung bestehen. Die Isolierung 4 besteht aus geschäumtem Isoliermaterial, wie beispielsweise Polyethylen oder Polypropylen. Es kann auch ein für hohe Temperaturen geeignetes Isoliermaterial eingesetzt werden, wie beispielsweise Fluorethylenpropylen (FEP) oder Polyfluoralken (PFA). Die Isolierung 4 kann in der bekannten "skin"-Technik mit einer glatten Außenhaut versehen sein. Die beiden Signaladern 1 und 2 sind miteinander verseilt. Über den Signaladern 1 und 2 ist eine gemeinsame Abschirmung 5 angebracht, welche aus einem elektrisch leitenden, metallisierten Kunststoffvlies besteht. Das Kunststoffvlies liegt beispielsweise als Band vor, das während der Verseilung der Signaladern 1 und 2 um dieselben lückenlos herumgewickelt wird.

Es solches Kunststoffvlies besteht in bevorzugter Ausführungsform aus Polyester. Es kann aber auch aus anderen geeigneten Kunststoffen bestehen. Seine Wandstärke bzw. Dicke liegt vorzugsweise zwischen 50 µm und 100 µm. Für seine Metallisierung wird ein elektrisch gut leitendes Metall verwendet, insbesondere Aluminium, Kupfer, Silber, Nickel oder eine cadmiumfreie Kupferlegierung. Es können auch zwei oder mehr unterschiedliche Metalle eingesetzt werden, die nacheinander aufgebracht werden können. Das Metall wird für die Metallisierung in den schmelzflüssigen Zustand überführt und aus der Dampfphase auf dem Vliesmaterial abgeschieden. Dabei dringt das Metall auch in das Vliesmaterial ein und umhüllt die dort befindlichen, ungeordnet zusammengehaltenen Fasern. Insgesamt wird auf und in dem Kunststoffvlies eine zwar poröse, aber nahezu geschlossene Metallschicht erzeugt, die eine Bedeckung von > 85 % für die umschlossenen Signaladern 1 und 2 ergibt.

In den beiden einander gegenüber liegenden Zwickeln zwischen den beiden Signaladern 1 und 2 ist außerhalb der Abschirmung 5 jeweils eine Versorgungsader 6 bzw. 7 angeordnet. Die Versorgungsadern 6 und 7 haben jede einen vorzugsweise wieder aus Kupfer bestehenden elektrischen Leiter 8, der von einer Isolierung 9 umgeben ist. Für den Leiter 8 können grundsätzlich die gleichen Materialien wie für den Leiter 3 der Signaladern 1 und 2 eingesetzt werden, so wie sie weiter oben beschrieben sind. Für die Isolierung 9 geeignete Isoliermaterialien sind beispielsweise Thermoplaste, thermoplastische Elastomere, strahlenvernetzte Polyolefine oder auch hochtemperaturbeständige Stoffe, wie FEP, PFA oder Polytetrafluorethylen. Da das Material der Abschirmung 5 als Vliesmaterial geringfügig dehnbar ist, wird es durch die Versorgungsadern 6 und 7 etwas in den jeweiligen Zwickel hineingedrückt. Die Abschirmung 5 erhält dadurch etwa das Aussehen einer offenen "8".

Die Durchmesser von Signaladern 1 und 2 einerseits und Versorgungsadern 6 und 7 andererseits, die zusammen die Seele der Leitung bilden, sind so aufeinander abgestimmt, daß sich für die Seele im Querschnitt eine etwa kreisrunde Form ergibt.

Um die Seele der Leitung ist eine äußere Abschirmung 10 herumgeformt, die ebenfalls aus einem elektrisch leitenden, metallisierten Kunststoffvlies besteht. Das Kunststoffvlies kann ebenso aufgebaut sein, wie das der Abschirmung 5.

In den verbleibenden freien Räumen neben den Versorgungsadern 6 und 7 ist mindestens eine Beilauflitze 1 1 positioniert, die vorzugsweise aus verzinnten Kupferdrähten besteht. Die Drähte der Beilauflitze 11 können aber auch aus den gleichen Materialien bestehen, wie sie für den Leiter 3 der Signaladern 1 und 2 oben angegeben sind. Die Beilauflitze 11 liegt sowohl an der Abschirmung 5 als auch an der äußeren Abschirmung 10 an. Vorzugsweise werden entsprechend der Darstellung in der Zeichnung zwei Beilauflitzen 11 eingesetzt, die beispielsweise auf beiden Seiten der Versorgungsader 6 liegen. Wenn der leitende Querschnitt der beiden Beilauflitzen 11 für einen wirksamen elektrischen Schirm für die Leitung ausreicht, können in den anderen freien Räumen strangförmige Füllelemente 12 aus Isoliermaterial angeordnet werden, beispielsweise auf beiden Seiten der Versorgungsader 7. Die jeweilige Anordnung von Beilauflitzen 11 und Füllelementen 12 ist aber beliebig. So können auch je eine Beilauflitze 1 und je ein Füllelement 12 neben den beiden Versorgungsadern 6 und 7 positioniert werden.

Über der äußeren Abschirmung 10 ist als weiteres Element des Schirms der Leitung eine vorzugsweise als Geflecht ausgeführte Schirmlage 13 aus elektrisch gut leitenden Drähten angeordnet. Die Schirmlage 13 kann auch als Umseilung ausgeführt sein. Ihre Drähte können wieder aus den gleichen Materialien wie der Leiter 3 der Signaladern 1 und 2 bestehen. Die Schirmlage 13 ist von einem Mantel 14 aus Isoliermaterial umgeben. Der Mantel 14 kann mittels eines Extruders aufgebracht werden. Er kann beispielsweise aus Polyvinylchlorid, aus einem halogenfreien flammwidrigen Polyolefin, aus einem thermoplastischen Elastomer, wie Polyetherurethan, oder aus einem olefinischen thermoplastischen Elastomer bestehen.

## Patentansprüche

1. Flexible elektrische Steuerleitung mit einer von einem Mantel aus Isoliermaterial umgebenen Seele, in welcher mindestens zwei der Datenübertragung dienende, von einer gemeinsamen Abschirmung (5) umgebene Signaladern(1,2), die jede einen von einer Isolierung (4) aus geschäumtem Isoliermaterial umgebenen elektrischen Leiter hat, und mindestens eine der Stromversorgung dienende Versorgungsader (6,7) angeordnet sind, die einen von einer Isolierung umgebenen elektrischen Leiter aufweist, **dadurch gekennzeichnet,**
- **daß** als Abschirmung (5) ein elektrisch leitendes, metallisiertes Kunststoffvlies lückenlos um die Signaladern (1,2) herumgeformt ist,
- **daß** in den beiden einander gegenüber liegenden Zwickeln zwischen den beiden Signaladern (1,2) außerhalb der Abschirmung (5) je eine Versorgungsader (6,7) angeordnet ist, durch welche die Abschirmung (5) etwas in den jeweiligen Zwickel hineingedrückt ist,
- **daß** die Durchmesser der Signaladern (1,2) und der in den Zwickeln zwischen denselben liegenden Versorgungsadern (6,7) so aufeinander abgestimmt sind, daß sich im Querschnitt der Leitung eine etwa kreisrunde Seele ergibt,
- **daß** neben mindestens einer der Versorgungsadern (6,7) mindestens eine Beilauflitze (11) aus elektrisch gut leitenden, metallischen Drähten positioniert ist, die sowohl an der Abschirmung (5) der Signaladern (1,2) als auch an einer gemeinsamen äußeren Abschirmung (10) anliegt, die aus einem elektrisch leitenden, metallisierten Kunststoffvlies besteht und über der Einheit aus Signaladern (1,2). Versorgungsadern (6,7) und Beilauflitze (11) angebracht ist, und
- **daß** die äußere Abschirmung (10) von einer Schirmlage (13) aus elektrisch gut leitenden, metallischen Drähten umgeben ist, über welcher der Mantel (14) angeordnet ist.

2. Leitung nach Anspruch 1, **dadurch gekennzeichnet, daß** die Leiter (3,9) von Signaladern (1,2) und Versorgungsadern (6,7) sowie die Drähte der Beilauflitze (11) und der Schirmlage (13) aus Kupfer oder aus mit Zinn, Silber oder Nickel beschichtetem Kupfer oder aus einer cadmiumfreien Kupferlegierung bestehen.

3. Leitung nach Anspruch 1 oder 2, **dadurch gekennzeichnet, daß** die Metallisierung des Kunststoffvlieses aus Kupfer, Aluminium, Silber, Nickel oder aus einer cadmiumfreien Kupferlegierung besteht.

4. Leitung nach Anspruch 3, **dadurch gekennzeichnet, daß** die Metallisierung des Kunstsoffvlieses aus mindestens zwei unterschiedlichen Metallen besteht.

5. Leitung nach einem der Ansprüche 1 bis 4, **dadurch gekennzeichnet, daß** die Isolierung (4) der Signaladern (1,2) eine glatte Außenhaut hat.

6. Leitung nach einem der Ansprüche 1 bis 5, **dadurch gekennzeichnet, daß** in den Räumen neben den Versorgungsadern (6,7), in denen keine Beilauflitze (11) angeordnet ist, strangförmige Füllelemente (12) aus Isoliermaterial angebracht sind.

## Claims

1. Flexible electric control cable comprising a core which is surrounded by a sheath of insulating material and arranged in which are-at least two signal wires (1, 2), which serve for data transmission, are surrounded by a common shielding (5) and each of which has an electrical conductor surrounded by an insulation (4) of foamed insulating material, and at least one supply wire (6, 7), which serves for the power supply and has an electrical conductor surrounded by an insulation, **characterized**
- **in that** an electrically conducting, metallized polymer nonwoven is formed around the signal wires (1, 2) without any gaps as the shielding (5) .
- **in that** arranged in the two mutually opposite interstices between the two signal wires (1, 2) outside the shielding (5) there is in each case a supply wire (6, 7), by which the shielding (5) is pressed somewhat into the respective interstice,
- **in that** the diameters of the signal wires (1, 2) and of the supply wires (6, 7) lying in the interstices between the same are made to match one another in such a way that an approximately circular core is obtained in the cross section of the cable,
- **in that** positioned alongside at least one of the supply wires (6, 7) is at least one filler strand (11) of metal wires with good electrical conduction, which lies both against the shielding (5) of the signal wires (1, 2) and against a common outer shielding (10), which comprises an electrically conducting, metallized polymer nonwoven and is provided over the unit comprising the signal wires (1, 2), the supply wires (6, 7) and the filler strand (11), and
- **in that** the outer shielding (10) is surrounded by a shielding layer (13) of metal wires with good electrical conduction, over which the sheath (14) is arranged.

2. Cable according to Claim 1, **characterized in that** the conductors (3, 9) of the signal wires (1, 2) and the supply wires (6, 7) and the wires of the filler strand (11) and of the shielding layer (13) consist of copper or of copper coated with tin, silver or nickel or of a cadmium-free copper alloy.

3. Cable according to Claim 1 or 2, **characterized in that** the metallization of the polymer nonwoven consists of copper, aluminium, silver, nickel or of a cadmium-free copper alloy.

4. Cable according to Claim 3, **characterized in that** the metallization of the polymer nonwoven consists of at least two different metals.

5. Cable according to one of Claims 1 to 4, **characterized in that** the insulation (4) of the signal wires (1, 2) has a smooth outer skin.

6. Cable according to one of Claims 1 to 5, **characterized in that** filling elements (12) of insulating material in strand form are provided in the spaces alongside the supply wires (6, 7) in which no filler strand (11) is arranged.

## Revendications

1. Ligne de commande électrique souple comprenant une âme entourée d'une enveloppe en matériau isolant dans laquelle sont disposés au moins deux fils de signaux (1, 2) servant à la transmission de données et entourés par un blindage commun (5), lesquels possèdent chacun un conducteur électrique entouré par un isolant (4) en matériau alvéolaire, et où est disposé au moins un fil d'alimentation (6, 7) servant à l'alimentation électrique, lequel présente un conducteur électrique entouré d'un isolant, **caractérisée en ce**
- **qu'**un voile en matière plastique métallisé électriquement conducteur faisant office de blindage (5) est façonné autour des fils de signaux (1, 2),
- **qu'**un fil d'alimentation (6, 7) par lequel le blindage (5) est légèrement enfoncé dans le bourrage correspondant est à chaque fois disposé à l'extérieur du blindage (5) dans les deux bourrages opposés l'un à l'autre des deux fils de signaux (1, 2),
- **que** le diamètre des fils de signaux (1, 2) et des fils d'alimentation (6, 7) qui se trouvent dans les bourrages entre ceux-ci sont adaptés les uns aux autres de manière à obtenir une âme approximativement circulaire dans la section transversale de la ligne,
- **qu'**à côté d'au-moins l'un des fils d'alimentation (6, 7) est placé au moins un cordon d'accompagnement (11) en fils métalliques bon conducteurs d'électricité, lequel repose à la fois contre le blindage (5) des fils de signaux (1, 2) et contre un blindage externe commun (10) qui se compose d'un voile métallisé électriquement conducteur et qui est appliqué sur l'ensemble constitué des fils de signaux (1, 2), des fils d'alimentation (6, 7) et du cordon d'accompagnement (11) et
- **que** le blindage externe (10) est entouré d'une couche de blindage (13) en fils métalliques bon conducteurs d'électricité au-dessus de laquelle est disposée l'enveloppe (14).

2. Ligne selon la revendication 1, **caractérisée en ce que** les conducteurs (3, 9) des fils de signaux (1, 2) et des fils d'alimentation (6, 7) ainsi que les fils du cordon d'accompagnement (1) et la couche de blindage (13) sont composés de cuivre ou de cuivre recouvert d'étain, d'argent ou de nickel ou encore d'un alliage de cuivre sans cadmium.

3. Ligne selon la revendication 1 ou 2, **caractérisée en ce que** la métallisation du voile en matière plastique se compose de cuivre, d'aluminium, d'argent, de nickel ou d'un alliage de cuivre sans cadmium.

4. Ligne selon la revendication 3, **caractérisée en ce que** la métallisation du voile en matière plastique se compose d'au moins deux métaux différents.

5. Ligne selon l'une des revendications 1 à 4, **caractérisée en ce que** l'isolant (4) des fils de signaux (1, 2) possède une peau extérieure lisse.

6. Ligne selon l'une des revendications 1 à 5, **caractérisée en ce que** des éléments de remplissage (12) en forme de corde en matériau isolant sont disposés dans les espaces à côté des fils d'alimentation (6, 7) dans lesquels ne se trouve aucun cordon d'accompagnement (11).
